# EUROPÄISCHE PATENTANMELDUNG

(11) **EP 2 330 623 A1**
(43) Veröffentlichungstag der Anmeldung: **08.06.2011**
(21) Anmeldenummer: 10187764.5
(22) Anmeldetag: 15.10.2010
(51) Int. Cl.: H01L 25/07

(54) **Druckkontaktiertes Leistungshalbleitermodul mit teilweise bandartigen Lastanschlusselementen**

(30) Priorität: 05.12.2009 DE 102009057145
(71) Anmelder: SEMIKRON Elektronik GmbH & Co. KG, 90431 Nürnberg (DE)
(72) Erfinder: Lederer, Marco, 90453 Nürnberg (DE)

(57) **Zusammenfassung**

Die Anmeldung betrifft ein Leistungshalbleitermodul in Druckkontaktausführung mit mindestens einem Substrat, hierauf angeordneten Leistungshalbleiterbauelementen, einem Gehäuse und nach außen führenden Lastanschlusselementen und mit einer Druckeinrichtung, wobei das Substrat auf seiner ersten dem Inneren des Leistungshalbleitermoduls zugewandten Hauptfläche Leiterbahnen mit Lastpotential aufweist. Ein erstes und mindestens ein weiteres Lastanschlusselement ist jeweils als Metallformkörper mit einem bandartigen Abschnitt und mit von diesem ausgehenden Kontaktfüßen ausgebildet, wobei der jeweilige bandartige Abschnitt parallel zur Substratoberfläche und von dieser beabstandet angeordnet ist und die Kontaktfüße von dem bandartigen Abschnitt zum Substrat reichen und dieses schaltungsgerecht kontaktieren. Weiterhin erfolgt die Druckübertragung von mindestens einem ersten bandartigen Abschnitt auf einen weiteren benachbarten bandartigen Abschnitt mittels einer Druckübertragungseinrichtung teilflächig, wobei diese Druckübertragungseinrichtung entweder als ein Druckzwischenstück und / oder als eine Verformung des bandartigen Abschnitts selbst ausgebildet ist.

## Beschreibung

Die Erfindung beschreibt ein Leistungshalbleitermodul in Druckkontaktausführung zur Anordnung auf einem Kühlbauteil. Einen Ausgangspunkt der Erfindung bilden Leistungshalbleitermodule wie sie beispielhaft aus der DE 197 19 703 A1 bekannt sind.

Derartige Leistungshalbleitermodule bestehen nach dem allgemeinen Stand der Technik in der Regel aus einem Gehäuse mit mindestens einem darin angeordneten elektrisch isolierenden Substrat vorzugsweise zur direkten Montage auf einem Kühlbauteil. Das Substrat seinerseits besteht aus einem Isolierstoffkörper mit einer Mehrzahl darauf befindlicher gegeneinander isolierter metallischer Leiterbahnen und hierauf befindlichen und mit diesen Leiterbahnen schaltungsgerecht verbundenen Leistungshalbleiterbauelementen. Weiterhin weisen die bekannten Leistungshalbleitermodule Anschlusselemente für externe Last- und Hilfsanschlüsse sowie im Inneren angeordnete Verbindungselemente auf. Diese Verbindungselemente für die schaltungsgerechten internen Verbindungen des Leistungshalbleitermoduls sind häufig als Drahtbondverbindungen ausgebildet.

Ebenfalls bekannt sind druckkontaktierte Leistungshalbleitermodule, wie sie in der DE 10 2006 006 423 A1 offenbart sind. Das Leistungshalbleitermodul gemäß dieser Druckschrift weist eine Druckkontaktausführung zur thermisch leitenden Verbindung des Leistungshalbleitermoduls mit einem Kühlbauteil auf. Ebenso ist in einem derartigen Leistungshalbleitermodul mindestens ein Substrat mit Leistungshalbleiterbauelementen angeordnet. Das Leistungshalbleitermodul weist zudem ein Gehäuse und nach außen führende Last- und Steueranschlusselemente auf. Das Substrat, beispielhaft ein DCB-Substrat, weist einen Isolierstoffkörper auf, auf dessen erster dem Inneren des Leistungshalbleitermoduls zugewandten Hauptfläche Leiterbahnen mit Lastpotential angeordnet sind.

Die offenbarten Lastanschlusselemente sind hier jeweils als Metallformkörper mit mindestens einer externen Kontakteinrichtung, einem bandartigen Abschnitt und mit von diesem ausgehenden Kontaktfüßen ausgebildet. Der jeweilige bandartige Abschnitt ist parallel zur Substratoberfläche und von dieser beabstandet angeordnet. Die Kontaktfüße reichen von dem bandartigen Abschnitt zum Substrat und kontaktieren dieses schaltungsgerecht. Zur elektrischen Isolation und Druckweiterleitung zwischen den einzelnen Lastanschlusselementen weisen diese im Bereich der jeweiligen bandartigen Abschnitte jeweils eine elastische Zwischenlage auf.

Die DE 10 2007 003 587 A1 offenbart schließlich ein Leistungshalbleitermodul der oben genannten Art, wobei ein Druckkörper zwischen der Druckeinrichtung und einem nicht direkt benachbarten weiteren Lastanschlusselement angeordnet ist. Hierbei reicht ein Teil dieses Druckkörpers durch das der Druckeinrichtung unmittelbar benachbarte Lastanschlusselement hindurch und übt somit Druck von der Druckeinrichtung direkt auf eine Druckaufnahmestelle dieses weiteren Lastanschlusselement aus.

Der Erfindung liegt die Aufgabe zugrunde ein ebenfalls Leistungshalbleitermodul in Druckkontaktausführung vorzustellen, wobei die Einleitung des Drucks auf mindestens ein Lastanschlusselement zu dessen Kontaktierung mit den Leiterbahnen des Substrats auf einfache Weise weiter verbessert wird.

Die Aufgabe wird erfindungsgemäß gelöst, durch ein Leistungshalbleitermodul mit den Merkmalen des Anspruchs 1. Bevorzugte Ausführungsformen sind in den abhängigen Ansprüchen beschrieben.

Der erfinderische Gedanke geht aus von einem auf einer Kühleinrichtung anordenbaren Leistungshalbleitermodul in Druckkontaktausführung mit mindestens einem Substrat, hierauf angeordneten Leistungshalbleiterbauelementen, beispielhaft IGBTs mit antiparallel geschalteten Dioden, einem Gehäuse und nach außen führenden Last- und Steueranschlusselementen. Das Substrat selbst weist hierzu einen Isolierstoffkörper auf und auf dessen erster, dem Inneren des Leistungshalbleitermoduls zugewandten, Hauptfläche Leiterbahnen mit Lastpotential. Weiterhin weist das Substrat vorzugsweise auch mindestens eine Leiterbahn mit Steuerpotential zu Ansteuerung der Leistungshalbleiterbauelemente auf.

Die Lastanschlusselemente dieses Leistungshalbleitermoduls sind jeweils ausgebildet als Metallformkörper mit einer Kontakteinrichtung, einem bandartigen Abschnitt und mit einer Mehrzahl von diesem ausgehenden Kontaktfüßen. Die jeweiligen bandartige Abschnitte sind parallel zur Substratoberfläche und von dieser beabstandet angeordnet. Die Kontaktfüße, die von dem bandartigen Abschnitt ausgehen reichen zum Substrat und bildet dort schaltungsgerecht den Kontakt des Lastanschlusselements aus. Vorzugsweise kontaktieren die Kontaktfüße hierzu auf dem Substrat die zugeordnete Leiterbahn mit Lastpotential, alternativ auch direkt die Leistungshalbleiterbauelemente.

Erfindungsgemäß erfolgt die Druckübertragung von mindestens einem ersten bandartigen Abschnitt auf einen weiteren benachbarten bandartigen Abschnitt mittels einer Druckübertragungseinrichtung teilflächig, vorteilhafterweise nur auf maximal einem fünften Teil der Fläche eines bandartigen Abschnitts. Die weist den Vorteil auf, dass der Druck auf diejenigen Flächenbereiche eingeleitet werden kann, denen in Druckrichtung fluchtend Kontaktfüße zugeordnet sind. Hierdurch wird also Druck gezielt auf Bereiche des bandartigen Abschnitts eingeleitet, die zur Kontaktsicherheit der elektrischen Verbindung zwischen Kontaktfüßen und Substrat notwendig sind.

Hierzu weist die Druckeinrichtung des Leistungshalbleitermoduls eine Druckübertragungseinrichtung auf, die entweder als ein Druckzwischenstück, als eine Verformung des bandartigen Abschnitts selbst oder als eine Kombination aus beiden ausgebildet ist.

Eine derartige Verformung des bandartigen Abschnitts ist vorteilhafterweise als eine prägetechnisch hergestellte Verformung mit einer Vertiefung auf einer ersten Seite des bandartigen Abschnitts und einer dieser zugeordneten Erhebung auf der gegenüberliegenden zweiten Seite des bandartigen Abschnitts ausgebildet ist.

Demgegenüber ist ein derartiges Druckzwischenstück vorteilhafterweise als ein Kunststoffformkörper ausgebildet, eine zugeordnete Hauptfläche eines ersten bandartigen Abschnitts vollständig oder teilweise bedeckt und, auf der dieser Hauptfläche abgewandten Seite, mindestens einen Druckkörper aufweist, der auf dem bandartigen Abschnitt des benachbarten Lastanschlusselements teilflächig aufliegt. Es kann ebenso bevorzugt sein, wenn dieses Druckzwischenstück gleichzeitig der Isolierung der beiden benachbarten bandartigen Abschnitte dient, indem es den ersten bandartigen Abschnitt bis zu seinen Rändern und über mindestens einen Rand hinaus bedeckt. Speziell hierbei kann es in Kombination mit der genannten Verformung vorteilhaft sein, wenn das Druckzwischenstück teilweise in einer Vertiefung der Verformung angeordnet ist, wodurch ein mechanische Fixierung erzielt wird, die selbstverständlich nicht auf den Fall der zusätzlichen isolierenden Funktion beschränkt ist.

Die erfinderische Lösung wird an Hand der Ausführungsbeispiele der Fig. 1 bis 5 weiter erläutert.

Fig. 1 zeigt einen Schnitt durch eine erste erfindungsgemäße Ausgestaltung ein Leistungshalbleitermoduls.

Fig. 2 zeigt analog Fig.1 wesentliche Elemente einer zweiten Ausgestaltung eines erfindungsgemäßen Leistungshalbleitermoduls.

Fig. 3 zeigt analog Fig.1 wesentliche Elemente einer dritten Ausgestaltung eines erfindungsgemäßen Leistungshalbleitermoduls.

Fig. 4 und 5 zeige zwei Ausgestaltungen eines Lastanschlusselementes eines erfindungsgemäßen Leistungshalbleitermoduls gemäß Fig. 2 in dreidimensionaler Darstellung.

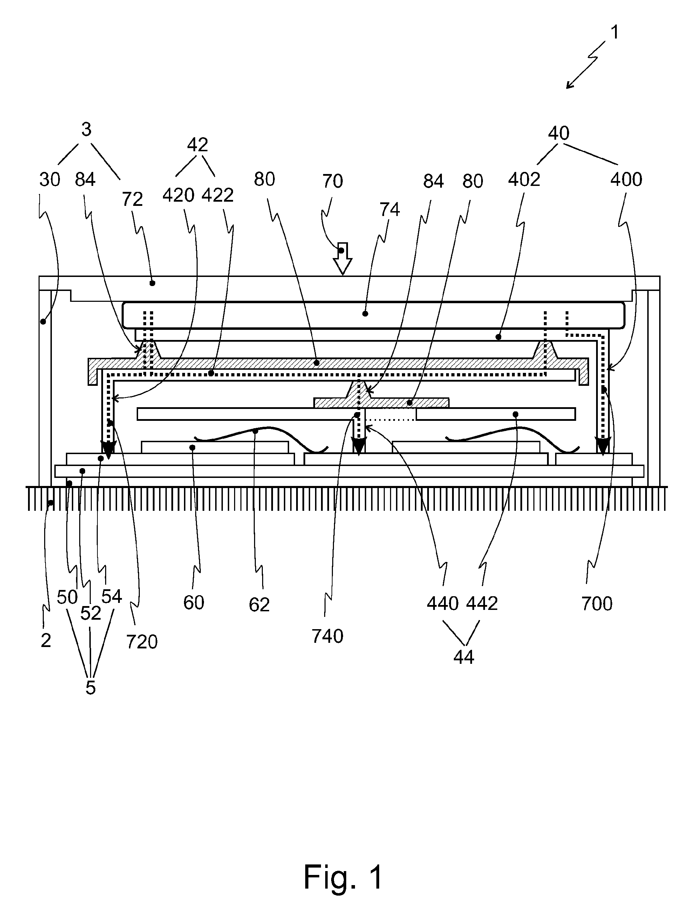

Fig. 1 zeigt einen Schnitt durch eine erste erfindungsgemäße Ausgestaltung ein Leistungshalbleitermoduls (1). Dieses weist ein Gehäuse (3) mit einem rahmenartigen Gehäuseteil (30) auf, der mit einem Kühlbauteil (2) verbindbar ist. Der rahmenartige Gehäuseteil (30) umschließt hierbei das mindestens eine Substrat (5). Dieses wiederum weist einen Isolierstoffkörper (52), vorzugsweise eine Isolierkeramik, wie Aluminiumoxid oder Aluminiumnitrit auf.

Auf der, dem Inneren des Leistungshalbleitermoduls (1) zugewandten, ersten Hauptfläche weist das Substrat (5) eine in sich strukturierte Metallkaschierung auf. Die einzelnen Abschnitte dieser vorzugsweise als Kupferkaschierung ausgestalteten Metallkaschierung bilden hierbei die Leiterbahnen (54) des Leistungshalbleitermoduls (1) aus. Die zweite Hauptfläche des Substrats (5) weist gemäß dem Stand der Technik eine nicht strukturierte Kupferkaschierung (50) auf.

Auf den Leiterbahnen (54) des Substrats (5) sind steuerbare, und / oder ungesteuerte Leistungshalbleiterbauelemente (60) wie beispielhaft IGBT's (insulated gate bipolar Transistor) mit jeweils antiparallel geschalteten Freilaufdioden, oder MOS-FETs angeordnet. Diese sind schaltungsgerecht mit weiteren Leiterbahnen (54), beispielhaft mittels Drahtbondverbindungen (62), verbunden.

Die Lastanschlusselemente (40, 42, 44) der verschiedenen notwendigen Potentiale dienen der externen Verbindung der leistungselektronischen Schaltung auf dem Substrat (5) des Leistungshalbleitermoduls (1). Hierzu sind die Lastanschlusselemente (40, 42, 44) als Metallformkörper ausgebildet, die je einen bandartigen Abschnitt (402, 422, 442) parallel zur Substratoberfläche aufweisen. Die bandartigen Abschnitte (402, 422, 442) bilden hierbei einen Stapel, wobei diese Abschnitte der einzelnen Lastanschlusselemente (40, 42, 44) jeweils gegeneinander elektrisch isoliert sind.

Von den jeweiligen bandartigen Abschnitten (402, 422, 442) reichen jeweils mehrere Kontaktfüße (400, 420, 440) zu den schaltungsgerecht zugeordneten Leiterbahnen (54) des Substrats (5).

Die schematisch dargestellte Druckeinrichtung (70) zur thermischen Verbindung des Leistungshalbleitermoduls (1) mit einem Kühlbauteil (2) und gleichzeitig zur elektrischen Kontaktierung der Kontaktfüße (400, 420, 440) der Lastanschlusselemente (40, 42, 44) mit den Leiterbahnen (54), des Substrats (5) weist neben den beschrieben bandartigen Abschnitten (402, 422, 442) der Lastanschlusselemente (40,42,44) noch ein Druckelement (72) zum Druckaufbau auf.

Dieses Druckelement (72) kann gemäß dem Stand der Technik als Kunststoffformkörper mit geeigneter innen liegender Metallseele, und /oder weiteren Versteifungsstrukturen ausgeführt sein. Es ist ebenso bevorzugt, wenn das Druckelement (72) gleichzeitig als Deckel des Leistungshalbleitermoduls (1) und somit als Teil des Gehäuses (3) dient. Zwischen diesem Druckelement (72) und dem in Druckrichtung ersten bandartige Abschnitte (402) eines Lastanschlusselements (40) ist ein Kissenelement (74) mit Federfunktion zur Druckspeicherung angeordnet.

Zur Druckübertragung vom Druckelement (72) über den Druckspeicher, den bandartigen Abschnitt (402), des im Stapel ersten Lastanschlusselements (40) auf den bandartigen Abschnitt (422) des zweiten Lastanschlusselements (42) ist zwischen diesen bandartigen Abschnitten eine Druckübertragungseinrichtung vorgesehen, die als ein als Druckzwischenstück in Form eines Kunststoffformkörper (80) ausgebildet ist, das die zugeordnete Hauptfläche des bandartigen Abschnitts (422) des zweiten Lastanschlusselements (42) vollständig bedeckt und über den Rand hinausragt, wodurch eine zusätzliche elektrisch, isolierende Zwischenlage zwischen dem ersten (40) und zweiten (42) Lastanschlusselements zumindest im Bereich der bandartigen Abschnitte (402, 422) ersetzt wird.

Dem ersten bandartigen Abschnitt (402) zugewandt weist das Druckzwischenstück (80) zwei Druckkörper (84) auf, die als Druckstege ausgebildet sind, wobei eine Anordnung, einer Mehrzahl von rotationssymmetrischen Drucknoppen in einer Reihe ebenso vorteilhaft sein kann. Erfindungsgemäß sind diese Druckkörper (84) mit dem ersten bandartigen Abschnitt (402) nur in teilflächigem Kontakt, wobei der linke Druckkörper annähernd fluchtend, mit in Druckrichtung darunter angeordneten Kontaktfüßen (400, 420, 440) vorgesehen ist. Die weitgehend symmetrische Anordnung des linken und rechten Druckkörpers (84) dient der gleichmäßigen Druckein- und Weiterleitung, dargestellt durch den Druckpfad (740) auf und über einen bandartigen Abschnitt (442) eines dritten Lastanschlusselements (44).

Zwischen dem zweiten und dritten bandartigen Abschnitten (422, 442) ist hierzu eine weiteres Druckzwischenstück (80) vorgesehen, das flächig, aber nicht vollflächig auf dem dritten bandartigen Abschnitt (442) aufliegt und zum zweiten bandartigen Abschnitt (422) hin einen Drucksteg (84) aufweist, der seinerseits in Druckrichtung fluchtend zu den Kontaktfüßen (440) des dritten Lastanschlusselements (44) angeordnet ist um hierauf gezielt den Druck einzuleiten.

Zur Verdeutlichung der Druckverhältnisse in der Druckeinrichtung (80,90) und der Ausbreitung dieser Druckverhältnisse entlang dreier Druckpfade (700, 720, 740) dienen die diese Druckpfade symbolisierenden gestrichelten Linien. Der Vorteil der erfindungsgemäßen Ausgestaltung des Leistungshalbleitermoduls (1) liegt somit in der dezidierten Druckein- und Weiterleitung zur Verbesserung der Kontaktsicherheit aller Kontaktfüße (400, 420, 440) mit den Leiterbahnen (54) des Substrats (5).

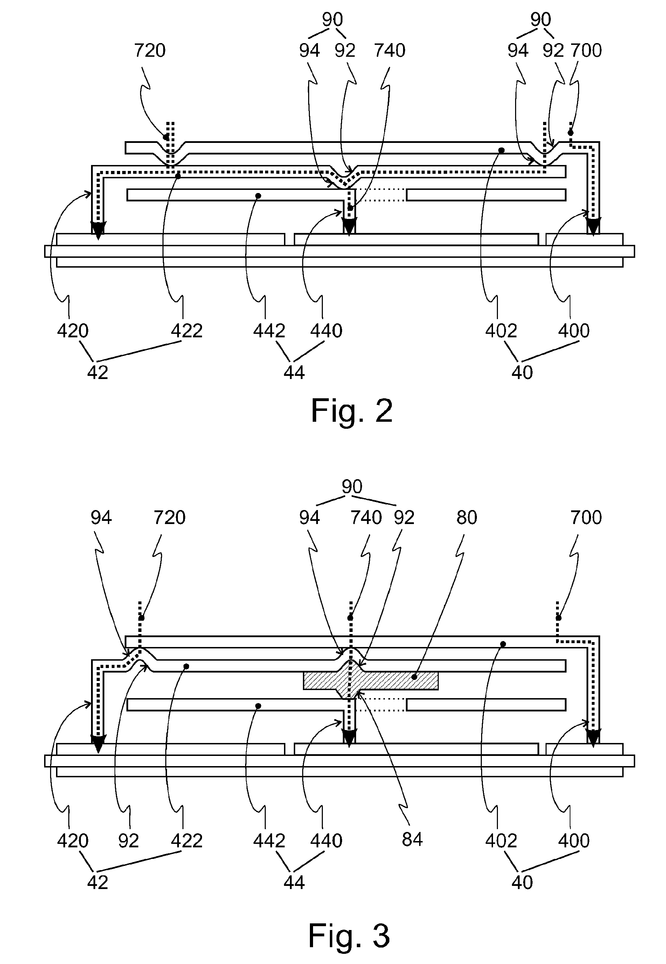

Fig. 2 zeigt analog Fig.1 wesentliche Elemente der Druckeinrichtung einer zweiten Ausgestaltung eines erfindungsgemäßen Leistungshalbleitermoduls (1). Dargestellt sind ausschließlich die jeweiligen bandartigen Abschnitte (402, 422, 442) und jeweiligen Kontaktfüße (400, 420, 440) von drei Lastanschlusselementen (40, 42, 44), ohne notwendige Einrichtung zur elektrischen Isolation der jeweiligen bandartigen Abschnitte. Der bandartige Abschnitt (402) des ersten Lastanschlusselements (40) weist als Druckübertragungseinrichtung zwei Verformungen (90) des bandartigen Abschnitts (402) selbst auf. Diese sind in Richtung der Zeichenebene jeweils als nach oben offene Rinne (92) mit zugeordnetem Drucksteg (94) auf der ihr gegenüber liegenden Seite ausgebildet.

In analoger Weise weist der bandartige Abschnitt (422) des zweiten Lastanschlusselementes (42) eine ebensolche Rinne (92), mit auf der ihr gegenüber liegenden Seite ausgebildetem, zugeordnetem Drucksteg (94) auf. Bei Druckeinleitung erfolgt die Druckverteilung mit gleicher Wirkung wiederum entlang der Druckpfade (700, 720, 740) gemäß Fig. 1.

Fig. 3 zeigt analog Fig.1 wesentliche Elemente der Druckeinrichtung einer dritten Ausgestaltung eines erfindungsgemäßen Leistungshalbleitermoduls (1). Dargestellt sind ausschließlich die jeweiligen bandartigen Abschnitte (402, 422, 442) und Kontaktfüße (400, 420, 440) von drei Lastanschlusselementen, (40, 42, 44) ohne notwendige Einrichtung zur elektrischen Isolation der jeweiligen bandartigen Abschnitte. Der bandartige Abschnitt (422) des zweiten Lastanschlusselements (42) weist als Druckübertragungseinrichtung zwei Verformungen (90) des bandartigen Abschnitts selbst auf. Diese sind in Richtung der Zeichenebene jeweils als nach unten offen Rinne (92) mit jeweils zugeordnetem Drucksteg (94) auf der ihr gegenüber liegenden Seite ausgebildet. Die linke Verformung (90) ist hierbei analog Fig. 2 angeordnet, während die zweite Verformung (90) mittig in Druckrichtung fluchtend mit den Kontaktfüßen (440) des dritten Lastanschlusselements (44) angeordnet ist.

Zur Druckweiterleitung vom zweiten (42) zum dritten Lastanschlusselement (44) ist zwischen diesen ein als Kunststoffformkörper (80) ausgebildetes Druckzwischenstück angeordnet. Dieser Kunststoffformkörper ist teilweise in der mittig angeordneten Rinne (92) des zweiten Lastanschlusselements (42) angeordnet, um ihn in seiner Lage zu fixieren. Bei dieser Ausgestaltung des erfindungsgemäßen Leistungshalbleitermoduls (1) ist es ausschließlich notwendige einen, hier den bandartigen Abschnitt (422) des zweiten Lastanschlusselement (42) gegenüber dem Stand der Technik weiterzubilden, da die Kombination eines Druckzwischenstücks (80) und dieses Lastanschlusselementes mit Verformung (90) bereits zur erfindungsgemäßen Verbesserung der Druckein- und Weiterleitung führt.

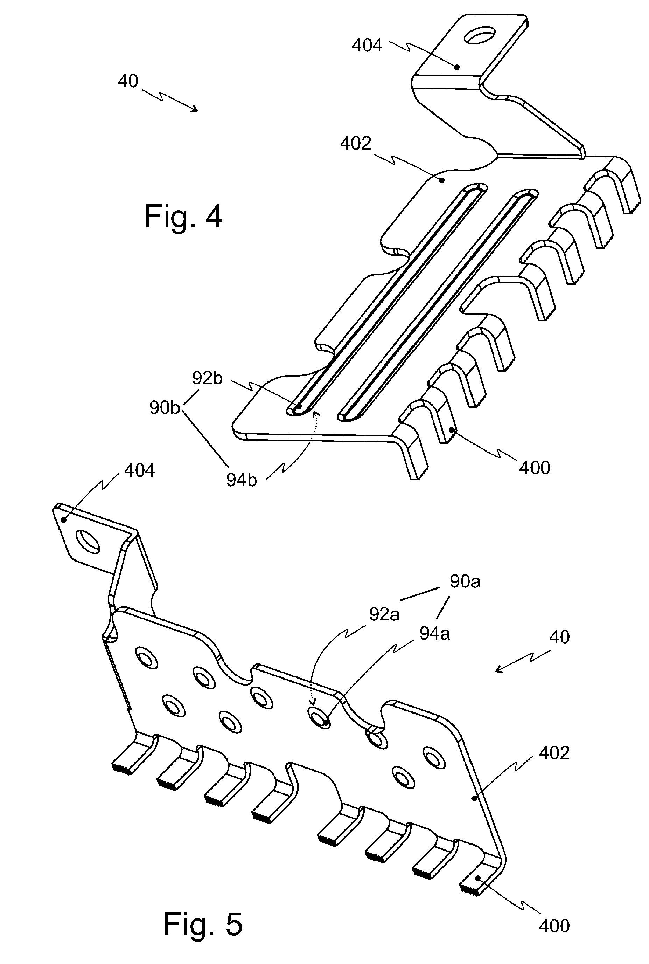

Fig. 4 und 5 zeigt zwei Ausgestaltungen eines beispielhaften Lastanschlusselementes (40) eines erfindungsgemäßen Leistungshalbleitermoduls (1) gemäß Fig. 2 in dreidimensionaler Darstellung. Dieses Lastanschlusselement (40) weist eine Kontakteinrichtung (404) zur externen elektrischen Verbindung des Leistungshalbleitermoduls (1) in dessen Fortsetzung den bandartigen Abschnitt (402) und von diesem ausgehend die Kontaktfüße (400) auf. Beide Ausgestaltungen gemäß Fig. 4 und 5 weisen in dem jeweiligen bandartigen Abschnitt prägetechnisch hergestellte Verformungen (90 a/b) mit jeweils einer Vertiefung (92 a/b) auf einer ersten Seite des bandartigen Abschnitts und jeweils einer dieser zugeordneten Erhebung (94 a/b) auf der gegenüberliegenden zweiten Seite des bandartigen Abschnitts auf.

In Fig. 4 sind diese Verformungen als Rinnen (92b) mit zugeordneten Druckstegen (94b) auf der gegenüberliegenden Seite ausgebildet, während gemäß Fig. 5 die Verformungen als rotationssymmetrische Vertiefung (92a) / Erhebung (94a) ausgebildet sind.

## Patentansprüche

1. Leistungshalbleitermodul (1) in Druckkontaktausführung mit mindestens einem Substrat (5), hierauf angeordneten Leistungshalbleiterbauelementen (60), einem Gehäuse (3) und nach außen führenden Lastanschlusselementen (40, 42, 44) und mit einer Druckeinrichtung (70), wobei das Substrat (5) auf seiner ersten dem Inneren des Leistungshalbleitermoduls zugewandten Hauptfläche Leiterbahnen (54) mit Lastpotential aufweist,
wobei ein erstes (40) und mindestens ein weiteres (42, 44) Lastanschlusselement jeweils als Metallformkörper mit einem bandartigen Abschnitt (402, 422, 442) und mit von diesem ausgehenden Kontaktfüßen (400, 420, 440) ausgebildet ist, der jeweilige bandartige Abschnitt (402, 422, 442) parallel zur Substratoberfläche und von dieser beabstandet angeordnet ist und die Kontaktfüße (400, 420, 440) von dem bandartigen Abschnitt (402, 422, 442) zum Substrat (5) reichen und dieses schaltungsgerecht kontaktieren, und
wobei die Druckübertragung von mindestens einem ersten bandartigen Abschnitt (402) auf einen weiteren benachbarten bandartigen Abschnitt (422) mittels einer Druckübertragungseinrichtung (80, 90) teilflächig erfolgt, und diese Druckübertragungseinrichtung (80, 90) entweder als ein Druckzwischenstück (80) und / oder als eine Verformung (90) des bandartigen Abschnitts (402, 422, 442) selbst ausgebildet ist.

2. Leistungshalbleitermodul (1) nach Anspruch 1, wobei
die Verformung (90) des bandartigen Abschnitts (402, 422, 442) als eine prägetechnisch hergestellte Verformung (90) mit einer Vertiefung (92) auf einer ersten Seite des bandartigen Abschnitts (402, 422, 442) und einer dieser zugeordneten Erhebung (94) auf der gegenüberliegenden zweiten Seite des bandartigen Abschnitts (402, 422, 442) ausgebildet ist.

3. Leistungshalbleitermodul (1) nach Anspruch 3, wobei
die Verformung (90) als rotationssymmetrische Vertiefung (92a) / Erhebung (94a) oder als Rinne (92b) mit zugeordnetem Drucksteg (94b) auf der ihr gegenüber liegenden Seite ausgebildet ist.

4. Leistungshalbleitermodul (1) nach Anspruch 1, wobei
das Druckzwischenstück (80) als ein Kunststoffformkörper ausgebildet ist.

5. Leistungshalbleitermodul (1) nach Anspruch 2, wobei
mindestens ein Druckzwischenstück (80) teilweise in einer Vertiefung (92 a/b) der Verformung (90) angeordnet ist.

6. Leistungshalbleitermodul (1) nach Anspruch 1, wobei
mindestens ein Druckzwischenstück (80) eine zugeordnete Hauptfläche eines bandartigen Abschnitts (402, 422, 442) vollständig oder teilweise bedeckt und, auf der dieser Hauptfläche abgewandten Seite, mindestens einen Druckkörper (84) aufweist.

7. Leistungshalbleitermodul (1) nach Anspruch 6, wobei
dieser Druckkörper (84) als rotationssymmetrische Drucknoppe oder als Drucksteg ausgebildet ist.

8. Leistungshalbleitermodul (1) nach Anspruch 6, wobei
das Druckzwischenstück (80) zur elektrischen Isolierung die zugeordnete Hauptfläche des bandartigen Abschnitts (402, 422, 442) bis zu den Rändern und über mindestens einen Rand hinaus bedeckt.

9. Leistungshalbleitermodul (1) nach Anspruch 1, wobei
die Druckeinrichtung (70) ausgebildet ist als ein Druck aufbauendes Druckstück (72) und ein zwischen diesem Druckstück (72) und dem ersten Lastanschlusselement (40) angeordneten Druckspeicher (74), vorzugsweise ausgebildet als dauerelastisches Kissenelement.

10. Leistungshalbleitermodul (1) nach Anspruch 1, wobei
die teilflächige Druckübertragung derart ausgebildet ist, dass der Druck mittels der Druckübertragungseinrichtung (80, 90) im Wesentlichen in Druckrichtung fluchtend auf die Kontaktfüße (400, 420, 440) eingeleitet wird.
